# EUROPEAN PATENT APPLICATION

(11) **EP 4 542 627 A1**
(43) Date of publication of application: **23.04.2025**
(21) Application number: 23823704.4
(22) Date of filing: 31.05.2023
(51) Int. Cl.: H01L 21/3065

(54) **SUBSTRATE PROCESSING METHOD AND SUBSTRATE PROCESSING SYSTEM**

(30) Priority: 14.06.2022 US 202263366346 P
(71) Applicant: Tokyo Electron Limited, Tokyo 107-6325 (JP)
(72) Inventor: IGETA, Masanobu, Tokyo 107-6325 (JP); TAKAHASHI, Yutaka, Oshu City, Iwate 023-1101 (JP); TAMURA, Tatsuya, Oshu City, Iwate 023-1101 (JP); SUZUKI, Yusuke, Hillsboro, Oregon 97124 (US); KAMADA, Toyohiro, Hillsboro, Oregon 97124 (US); OYAMA, Kenichi, Oregon (US); TSUZUKI, Reiko, Nirasaki City, Yamanashi 407-0192 (JP); NAGAHARA, Seiji, Tokyo 107-6325 (JP); MURAMATSU, Makoto, Koshi City, Kumamoto 861-1116 (JP); MURAMATSU, Satoru, Tokyo 107-6325 (JP); SHIMURA, Satoru, Koshi City, Kumamoto 861-1116 (JP)
(74) Representative: Hoffmann Eitle
(86) International application number: PCT/JP2023/020329
(87) International publication number: WO 2023/243410

(57) **Abstract**

A substrate processing method and a substrate processing system that improve line edge roughness of a pattern formed in an underlayer in a case where the underlayer is etched by using a metal oxide resist film as a mask. The substrate processing method comprising: a step of forming a metal oxide resist film on a substrate including the underlayer; a step of forming a pattern in the metal oxide resist film; a step of modifying the metal oxide resist film in which the pattern has been formed; and a step of etching the underlayer by using the modified metal oxide resist film as a mask.

## Description

### TECHNICAL FIELD

The present disclosure relates to a substrate processing method and a substrate processing system.

### BACKGROUND

Patent Document 1 and Patent Document 2 disclose substrate processing methods for patterning using a resist made of a metal oxide in EUV lithography processing.

### Related Art Document

### Patent Document

Patent Document 1: US Patent Application Publication No. 2021/305048
Patent Document 2: US Patent Application Publication No. 2020/326627

### SUMMARY OF THE INVENTION

### Problem to be solved by the invention

In one aspect, the present disclosure provides a substrate processing method and a substrate processing system that improve line edge roughness of a pattern formed on an underlayer when the underlayer is etched using a metal oxide resist film as a mask.

### Means for Solving the Problem

According to one aspect, in order to solve the above-described problem, a substrate processing method including a step of forming a metal oxide resist film on a substrate including an underlayer; a step of forming a pattern in the metal oxide resist film; a step of modifying the metal oxide resist film in which the pattern has been formed; and a step of etching the underlayer by using the modified metal oxide resist film as a mask is provided.

### Effect of the invention

According to one aspect, a substrate processing method and a substrate processing system that improve line edge roughness of a pattern formed on an underlayer when the underlayer is etched using a metal oxide resist film as a mask can be provided.

### BRIEF DESCRIPTION OF THE DRAWINGS

[FIG. 1] FIG. 1 is an example of a flowchart illustrating a substrate processing method according to a first embodiment.
[FIG. 2] FIG. 2 is an example of a schematic cross-sectional view of a substrate after a MOR film formation process.
[FIG. 3] FIG. 3 is an example of a schematic cross-sectional view of the substrate after a development process.
[FIG. 4] FIG. 4 is an example of a schematic cross-sectional view of the substrate after a modification process.
[FIG. 5] FIG. 5 is an example of a schematic cross-sectional view of the substrate after an etching process.
[FIG. 6] FIG. 6 is an example of a graph indicating line edge roughness of a pattern formed on an underlayer.
[FIG. 7] FIG. 7 is an example of a flowchart illustrating a substrate processing method according to a second embodiment.
[FIG. 8] FIG. 8 is an example of a schematic cross-sectional view of the substrate before an annealing process.
[FIG. 9] FIG. 9 is an example of a schematic cross-sectional view of the substrate after the annealing process.
[FIG. 10] FIG. 10 is an example of a cross-sectional view of the substrate before the annealing process.
[FIG. 11] FIG. 11 is an example of a cross-sectional view of the substrate after the annealing process.
[FIG. 12] FIG. 12 is an example of a flowchart illustrating a substrate processing method according to a third embodiment.
[FIG. 13] FIG. 13 is an example of a flowchart illustrating a protective film formation process.
[FIG. 14] FIG. 14 is an example of a schematic cross-sectional view of the substrate before the protective film formation process.
[FIG. 15] FIG. 15 is an example of a schematic cross-sectional view of the substrate after the protective film formation process.
[FIG. 16] FIG. 16 is a schematic cross-sectional view illustrating an example of a film deposition apparatus for forming a protective film.
[FIG. 17] FIG. 17 is a schematic perspective view illustrating a configuration inside a vacuum chamber of the film deposition apparatus.
[FIG. 18] FIG. 18 is a schematic plan view illustrating the configuration inside the vacuum chamber of the film deposition apparatus.
[FIG. 19] FIG. 19 is an example of a graph indicating line edge roughness.
[FIG. 20] FIG. 20 is a view illustrating a result of a trench shape in a case where the annealing process is omitted and the protective film is formed.
[FIG. 21] FIG. 21 is a view illustrating a result of a trench shape in a case where the annealing is performed and the protective film is formed.
[FIG. 22] FIG. 22 is an example of a flowchart illustrating a substrate processing method according to a fourth embodiment.
[FIG. 23] FIG. 23 is a block diagram illustrating an example of a substrate processing system.

### DESCRIPTION OF THE EMBODIMENTS

In the following, various exemplary embodiments will be described in detail with reference to the drawings. Here, in the drawings, the same or corresponding parts are denoted by the same reference symbols.

### <First Embodiment>

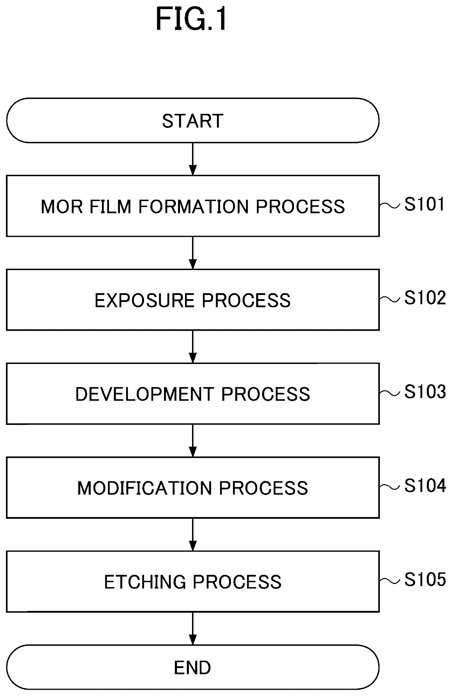

An example of a substrate processing method according to a first embodiment will be described with reference to FIGS. 1 to 5.

FIG. 1 is an example of a flowchart illustrating the substrate processing method according to the first embodiment.

In step S101, a process (a MOR film formation process) of forming, on a substrate including an underlayer, a metal oxide resist film (hereinafter, also referred to as a MOR film) 640 made of a metal oxide is performed.

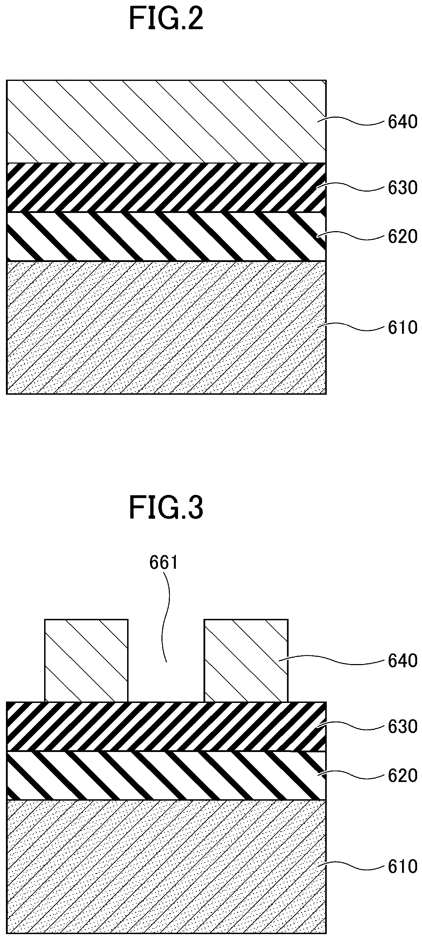

FIG. 2 is an example of a schematic cross-sectional view of the substrate after the MOR film formation process.

Here, the substrate before the MOR film formation process includes a base material 610 and an underlayer (an organic film 620 and a silicon-containing film 630). The base material 610 is made of, for example, Si, SiO₂, SiN, TiN, or the like. The underlayer is formed on the base material 610. In the example illustrated in FIG. 2, as the underlayer, a laminated structure of the organic film 620 and the silicon-containing film 630 is formed. The organic film 620 is formed on the base material 610. The organic film 620 is, for example, a carbon film. The silicon-containing film 630 is formed on the organic film 620. The silicon-containing film 630 is, for example, a spin on glass (SOG) film. The silicon-containing film 630 is made of, for example, SiOC, SiOCN, SiC, TiO₂, SnO₂, carbon, or the like. Here, the configuration of the underlayer is not limited thereto. The underlayer may instead be only the organic film 620 or the silicon-containing film 630.

In the MOR film formation process, the MOR film 640 is formed on the underlayer of the substrate. In the example illustrated in FIG. 2, the MOR film 640 is formed on the silicon-containing film 630. The MOR film 640 is made of a metal oxide containing at least a metal atom and an oxygen atom (0). Alternatively, the MOR film 640 may be a metal oxide containing an alkyl group. The metal atom included in the MOR film 640 includes at least one of, for example, Sn, Sb, In, Ti, Zr, Hf, V, Co, Mo, W, Al, Ga, Si, Ge, P, As, Y, La, Ce, Lu, or the like.

A method of forming the MOR film 640 may be, for example, forming by plasma chemical vapor deposition (CVD) using an organic metal-containing gas and an oxidizing gas. The organic metal-containing gas contains an alkyl group and a metal atom. As the organic metal-containing gas, for example, at least one of trimethyltin chloride (Me₃SnCl), dimethyltin dichloride (Me₂SnCl₂), methyltin trichloride (MeSnCl₃), tris (dimethylamino) methyltin (IV) ((Me₂N)₃SnMe), (dimethylamino) trimethyltin (IV) ((Me₂N)SnMe₃), or the like can be used. Additionally, the oxidizing gas contains an oxygen atom (0). As the oxidizing gas, for example, at least one of O₂, O₃, H₂O₂, H₂O, or the like can be used. Additionally, the method of forming the MOR film 640 is not limited to a dry process, may be a wet process, and is not limited.

Next, a process of forming a pattern in the MOR film 640 is performed. First, in step S102, an exposure process is performed on the substrate including the MOR film 640. Next, in step S103, a development process is performed on the substrate including the MOR film 640. Here, the MOR film 640 may be a positive resist film in which an exposed portion in the exposure process is removed by the development process, or may be a negative resist film in which an unexposed portion in the exposure process is removed by the development process.

FIG. 3 is an example of a schematic cross-sectional view of the substrate after the development process. A pattern of an opening 661 is formed in the MOR film 640 by the exposure process and the development process.

In step S104, a modification process is performed on the substrate including the MOR film 640 in which the pattern of the opening 661 has been formed. Here, the modification process modifies the MOR film 640 in which the pattern has been formed. Additionally, the modification process is an oxidation process. Specifically, the modification process exposes the substrate to an oxygen-containing gas atmosphere. The oxygen-containing gas is, for example, a peroxide (H₂O₂) gas, an ozone (O₃) gas, or both. For example, the temperature of the modification process is 100 to 350°C, the pressure is 1.2 to 120 Torr, and the processing time is 100 to 1,200 seconds. This further oxidizes the MOR film 640 to form a modified MOR film 645. For example, when the MOR film 640 is made of a metal oxide containing an alkyl group, the alkyl group is removed by the oxidation process, and oxygen atoms (O) are bonded.

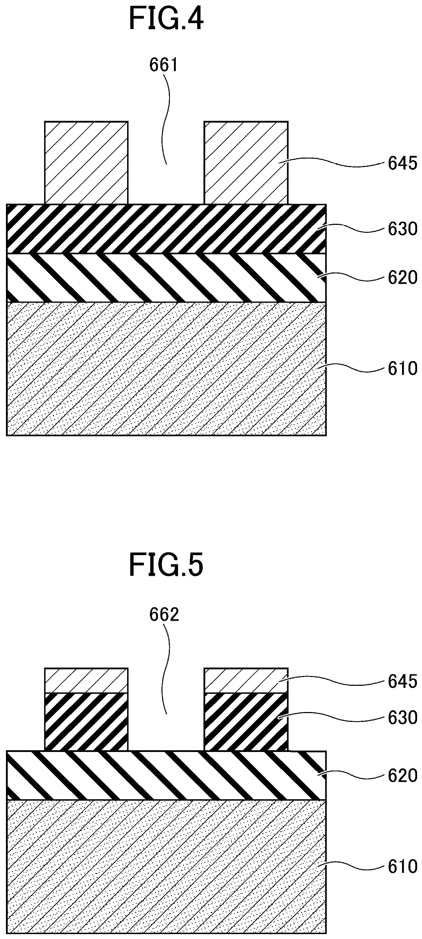

FIG. 4 is an example of a schematic cross-sectional view of the substrate after the modification process. The MOR film 640 is modified by the modification process to form the modified MOR film 645.

In step S105, an etching process is performed on the substrate including the modified MOR film 645 in which the pattern of the opening 661 has been formed. Here, the underlayer (the silicon-containing film 630 and the organic film 620) are etched using, as a mask, the modified MOR film 645 in which the pattern has been formed, to form a pattern in the underlayer.

FIG. 5 is an example of a schematic cross-sectional view of the substrate after the etching process. By the etching process, a pattern of a recess 662 is formed in the silicon-containing film 630.

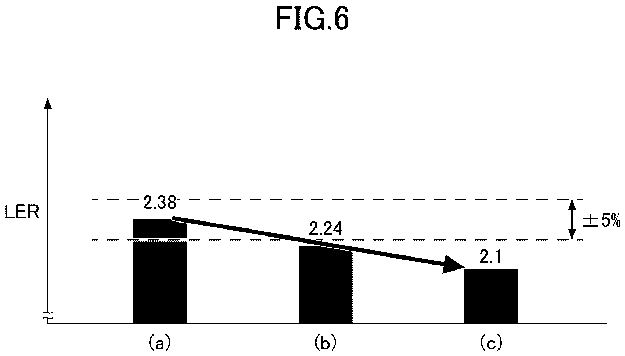

Here, the linearity of an edge (sidewall) of the trench-shaped pattern formed in the underlayer will be described with reference to FIG. 6. FIG. 6 is an example of a graph indicating line edge roughness (LER) of the pattern that has been formed in the underlayer.

Here, in step S102 and step S103, the trench-shaped pattern was formed in the MOR film 640. Then, in step S105, the etching process was performed on the silicon-containing film 630, which was the underlayer, using the MOR film 640 or the modified MOR film 645 having the trench-shaped pattern as a mask, thereby forming the trench-shaped pattern in the silicon-containing film 630. The line edge roughness (LER) in the trench-shaped pattern that had been formed in the silicon-containing film 630 was measured.
(a) indicates the line edge roughness (LER) in a case where step S104 is omitted and the underlayer is etched using the unmodified MOR film 640. Additionally, in FIG. 6, a range of ±5% from the line edge roughness (LER) in (a) is illustrated by the dashed lines.
(b) indicates the line edge roughness (LER) in a case where the modification process is performed on the substrate by the hydrogen peroxide (H₂O₂) gas in step S104 and the underlayer is etched using the modified MOR film 645.
(c) indicates the line edge roughness (LER) in a case where the modification process is performed on the substrate by the ozone (O₃) gas in step S104 and the underlayer is etched using the modified MOR film 645.

As illustrated in FIG. 6, by forming the trench-shaped pattern in the underlayer by using the modified MOR film 645 that is modified using the hydrogen peroxide (H₂O₂) gas, the ozone (O₃) gas, or both illustrated in (b) and (c), the line edge roughness can be reduced (see the arrow in FIG. 6) in comparison with the case where the trench-shaped pattern is formed on the underlayer by using the MOR film 640 on which the modification process is not performed, illustrated in (a).

With this, the line edge roughness of the pattern formed in the underlayer can be improved. Additionally, when the organic film 620 is etched using, as a mask, the silicon-containing film 630 in which the pattern of the recess 662 has been formed, to form the pattern in the organic film 620, the line edge roughness in the pattern formed in the organic film 620 can also be improved. Additionally, when the base material 610 is etched using, as a mask, the underlayer in which the pattern has been formed, to form a pattern in the base material 610, the line edge roughness in the pattern formed in the base material 610 can also be improved. Additionally, by modifying the MOR film 640, the etching resistance is also improved. Here, as the line edge roughness is improved, the line width roughness (LWR) is also improved.

### <Second Embodiment>

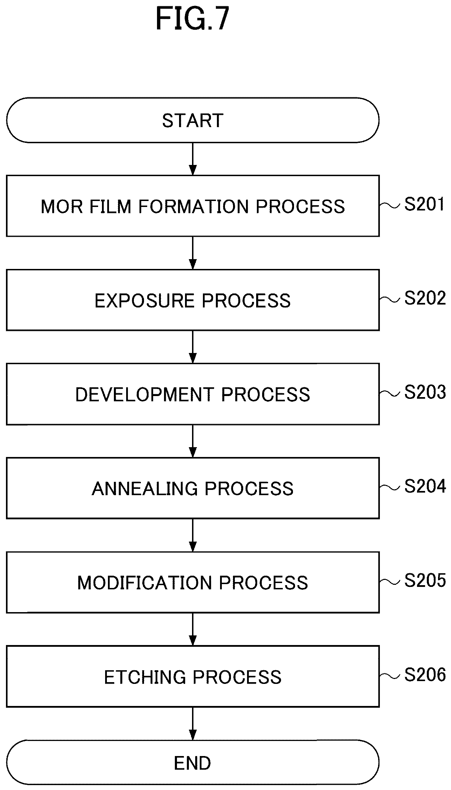

Next, an example of a substrate processing method according to a second embodiment will be described with reference to FIGS. 7 to 9.

FIG. 7 is an example of a flowchart illustrating the substrate processing method according to the second embodiment.

In step S201, the process (the MOR film formation process) of forming the MOR film 640 made of a metal oxide is performed on the substrate including the underlayer. Next, the process of forming the pattern in the MOR film 640 is performed. First, in step S202, the exposure process is performed on the substrate. Next, in step S203, the development process is performed on the substrate. Here, the processes from step S201 to step S203 are substantially the same as the processes from step S101 to step S103 (see FIG. 1), and thus the duplicated description will be omitted.

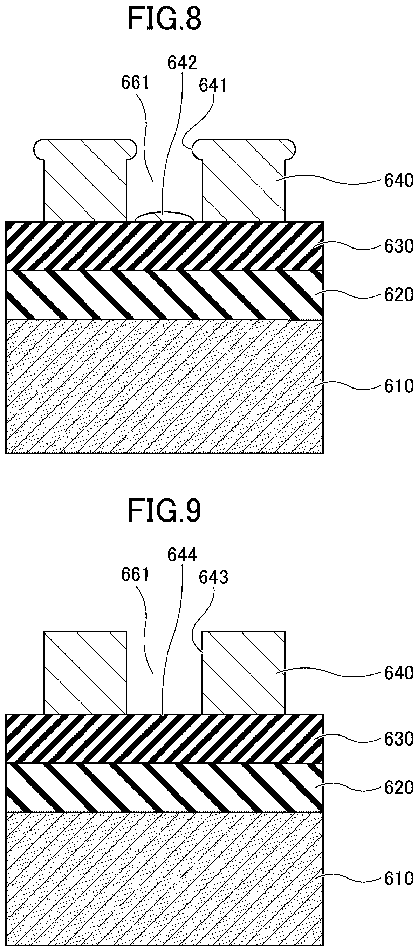

FIG. 8 is an example of a schematic cross-sectional view of the substrate before an annealing process. The pattern of the opening 661 is formed in the MOR film 640 by the exposure process and the development process. Here, a projection 641 is formed that projects from the upper portion of the sidewall of the MOR film 640 toward the opening 661. In other words, the cross-sectional shape of the MOR film 640 is substantially a T-shape in which the upper portion is enlarged in the width direction. Additionally, on an upper surface of the silicon-containing film 630 in the opening 661, there is a residue 642 due to the development process.

In step S204, the annealing process is performed on the substrate. Here, the annealing process is performed under the processing conditions of a substrate temperature of 150°C to 400°C, a pressure of 1 to 500 Torr, and a processing time of 30 to 60 minutes in an inert gas atmosphere. As the inert gas, N₂ gas, Ar gas, a mixture gas of N₂ gas and Ar gas, or the like can be used.

FIG. 9 is an example of a schematic cross-sectional view of the substrate after the annealing process. The annealing process improves the shape of a sidewall 643 of the MOR film 640. Additionally, the residue 642 (see FIG. 8) on an upper surface 644 of the silicon-containing film 630 in the opening 661 is removed or reduced.

In step S205, the modification process is performed on the substrate. Next, in step S206, the etching process is performed on the substrate. The processes from step S205 to step S206 are substantially the same as the processes from step S104 to step S105 (see FIG. 1), and thus the duplicated description will be omitted. With this, the pattern of the recess 662 is formed in the silicon-containing film 630 (see FIG. 5).

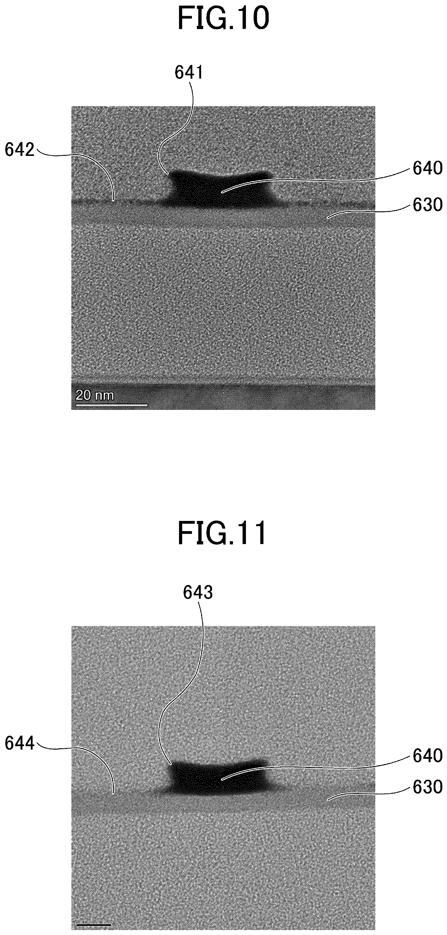

Here, the shapes of the formed MOR film 640 before the annealing process and after the annealing process will be described with reference to FIGS. 10 and 11.

FIG. 10 is an example of a cross-sectional view of the substrate before the annealing process. As illustrated in FIG. 10, the projection 641 is formed, projecting from the upper portion of the sidewall of the MOR film 640 toward the opening 661. In other words, the cross-sectional shape of the MOR film 640 is a T-shape in which the upper portion is enlarged in the width direction. Additionally, on the upper surface of the silicon-containing film 630 in the opening 661, there is the residue 642.

FIG. 11 is an example of a cross-sectional view of the substrate after the annealing process. As illustrated in FIG. 11, the annealing process shapes the sidewall 643 of the MOR film 640. Additionally, the residue 642 (see FIG. 8) is removed from the upper surface 644 of the silicon-containing film 630 in the opening 661.

The annealing process can improve the line edge roughness (LER) of the sidewall 643 of the MOR film 640. This can also improve the line edge roughness (LER) of the recess 662 of the silicon-containing film 630 formed by the etching process using the modified MOR film 645 as a mask. Additionally, when the organic film 620 is etched using, as a mask, the silicon-containing film 630 in which the pattern of the recess 662 has been formed, to form the pattern in the organic film 620, the line edge roughness of the pattern formed in the organic film 620 can also be improved. Additionally, when the base material 610 is etched using, as a mask, the underlayer in which the pattern has been formed, to form the pattern in the base material 610, the line edge roughness of the pattern formed in the base material 610 can also be improved. Here, as the line edge roughness is improved, the line width roughness (LWR) is also improved.

### <Third Embodiment>

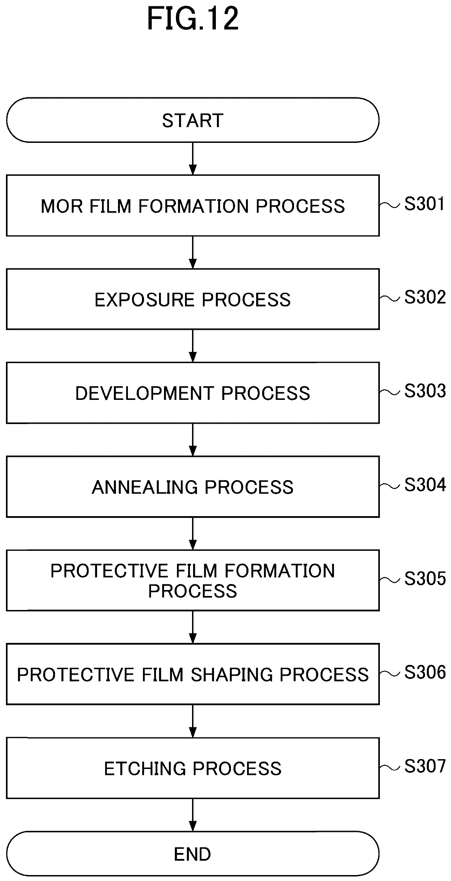

Next, an example of a substrate processing method according to a third embodiment will be described with reference to FIGS. 12 to 15.

FIG. 12 is an example of a flowchart illustrating the substrate processing method according to the third embodiment.

In step S301, the process (the MOR film formation process) of forming the MOR film 640 made of a metal oxide is performed on the substrate including the underlayer. Next, the process of forming the pattern in the MOR film 640 is performed. First, in step S302, the exposure process is performed on the substrate. Next, in step S303, the development process is performed on the substrate. Next, in step S304, the annealing process is performed on the substrate. Here, the processes from step S301 to step S304 are substantially the same as the processes from step S201 to step S204 (see FIG. 7), and thus the duplicated description will be omitted. Here, the annealing process in step S304 may be omitted.

In step S305, a process (a protective film formation process) of forming a protective film 650 on an upper portion of the MOR film 640 is performed. Here, the protective film formation process in the step S305 also includes a modification process of the MOR film 640.

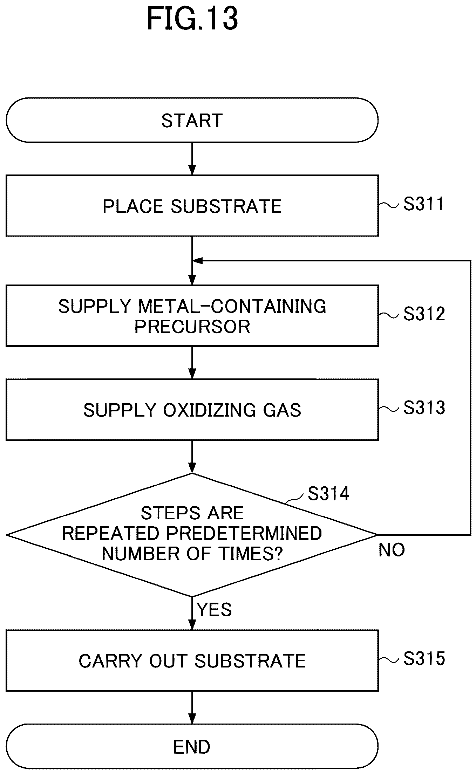

Here, an example of the protective film formation process in step S305 will be described with reference to FIG. 13. FIG. 13 is an example of a flowchart illustrating the protective film formation process.

In step S311, the substrate is placed on a mounting section of the substrate processing apparatus.

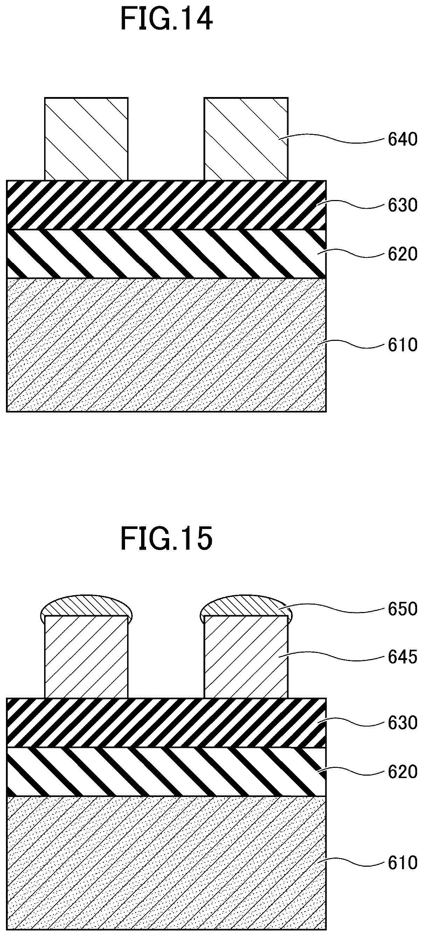

FIG. 14 is an example of a schematic cross-sectional view of the substrate before the protective film formation process. Here, the MOR film 640 in which the pattern has been formed is provided on the underlayer (the organic film 620 and the silicon-containing film 630).

In step S312, a metal-containing precursor, which is a source gas, is supplied to the substrate. With this, the metal-containing precursor is adsorbed on the surface of the substrate. Here, the metal-containing precursor is selectively adsorbed on a non-recessed shape formed region of the MOR film 640 (the upper portion of the MOR film 640) rather than a recessed shape formed region of the MOR film 640 (a lower portion in the opening 661).

In step S313, an oxidizing gas, which is a reactive gas, is supplied to the substrate. Here, as the oxidizing gas, a peroxide (H₂O₂) gas, an ozone (O₃) gas, or both can be used. With this, the metal-containing precursor adsorbed on the surface of the substrate is oxidized to form the protective film 650. Additionally, an oxidation process (corresponding to the modification process in step S104) is performed on the MOR film 640 by the oxidizing gas, and the MOR film 640 is further oxidized to form the modified MOR film 645.

In step S314, it is determined whether the processes from step S312 to step S313 have been repeated a predetermined number of times. If the processes have not been repeated the predetermined number of times (NO in S314), the processes from step S312 to step S313 are repeated. If the processes have been repeated the predetermined number of times (YES in S314), the process proceeds to step S315.

In step S315, the substrate is carried out from the substrate processing apparatus.

FIG. 15 is an example of a schematic cross-sectional view of the substrate after the protective film formation process. The protective film formation process in step S305 also includes the modification process of the MOR film 640. Thus, the MOR film 640 (see FIG. 14) is modified by the oxygen-containing gas to be the modified MOR film 645. Additionally, the protective film 650 is formed in the non-recessed shape formed region of the modified MOR film 645. In other words, the protective film 650 is formed on the upper portion of the modified MOR film 645. The protective film 650 is, for example, any of a titanium oxide film, a titanium oxynitride film, an aluminum oxide film, or a silicon oxide film. Additionally, the protective film 650 has a higher etching resistance than the silicon-containing film 630 under the condition of the etching process in the step S307 described later.

In step S306, the protective film shaping process is performed on the substrate. Here, for example, the protective film 650 that has been formed on the upper surface 644 of the silicon-containing film 630 is removed. For example, in step S305, the protective film 650 is formed thicker in the non-recessed shape formed region (the upper portion of the modified MOR film 645) than in the recessed shape formed region (the lower portion in the opening 661). In step S306, the protective film 650 in the recessed shape formed region is removed by the etching process while the protective film 650 in the non-recessed shape formed region is left.

In step S307, the etching process is performed on the substrate. Here, the process of step S307 is substantially the same as the process of step S105 (see FIG. 1), and thus the duplicated description will be omitted. With this, the pattern of the recess 662 is formed in the silicon-containing film 630 (see FIG. 5). Additionally, the protective film 650 has a higher etching resistance than the silicon-containing film 630. With this, the selectivity of the etching process is improved. Additionally, the number of steps can be reduced by collectively performing the modification process and the protective film formation process.

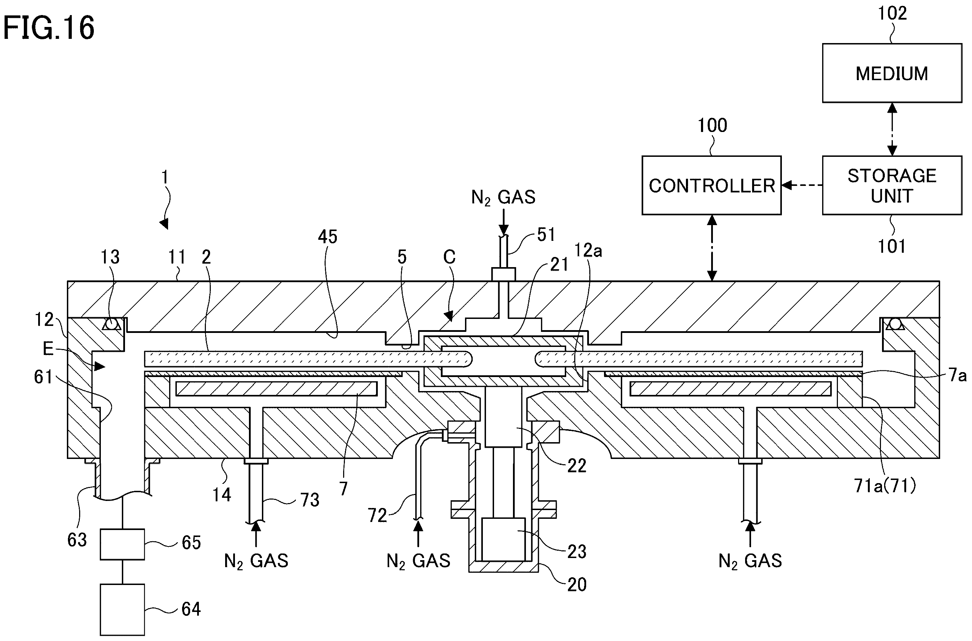

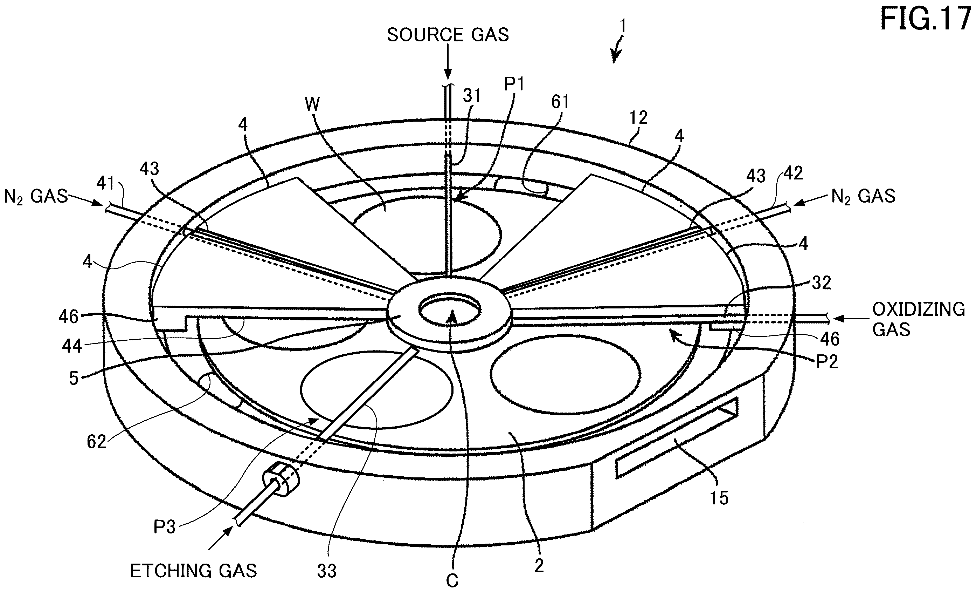

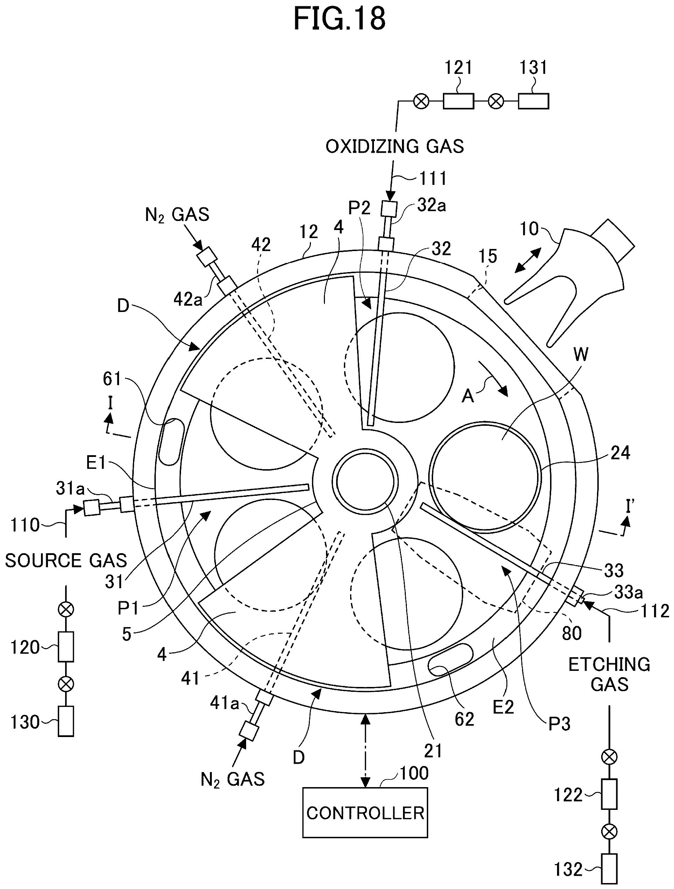

Here, an example of the substrate processing apparatus used for the protective film formation process in step S305 will be described with reference to FIGS. 16 to 18. FIG. 16 is a schematic cross-sectional view illustrating an example of the film deposition apparatus for forming the protective film 650. FIG. 17 is a schematic perspective view illustrating a configuration inside a vacuum chamber of the film deposition apparatus. FIG. 18 is a schematic plan view illustrating the configuration inside the vacuum chamber of the film deposition apparatus.

Referring to FIGS. 16 to 18, the film deposition apparatus includes a flat vacuum chamber 1 having a substantially circular planar shape, and a rotary table 2 provided inside the vacuum chamber 1 and having a rotation center at the center of the vacuum chamber 1. The vacuum chamber 1 is a processing chamber for performing a film deposition process on a surface of a wafer accommodated therein. The vacuum chamber 1 includes a chamber body 12 having a cylindrical shape with a bottom, and a top plate 11 airtightly and detachably disposed on an upper surface of the chamber body 12 via a seal member 13 (see FIG. 16) such as, an O-ring.

The rotary table 2 is fixed to a core 21 having a cylindrical shape at the center thereof, and the core 21 is fixed to an upper end of a rotary shaft 22 extending in the vertical direction. The rotary shaft 22 penetrates a bottom 14 of the vacuum chamber 1, and a lower end of the rotary shaft 22 is attached to a drive section 23 that rotates the rotary shaft 22 (FIG. 16) around the vertical axis. The rotary shaft 22 and the drive section 23 are accommodated in a cylindrical case body 20 having an open upper surface. A flange portion provided on the upper surface of the case body 20 is airtightly attached to a lower surface of the bottom 14 of the vacuum chamber 1, and the airtight state between the internal atmosphere and the external atmosphere of the case body 20 is maintained.

In the protective film formation process, when the protective film 650 is grown upward, the rotary table 2 is rotated at a high speed equal to or greater than 120 rpm, for example, at a predetermined speed in a range of 120 rpm to 300 rpm. Thus, the drive section 23 is configured to rotate the rotary table 2 at a high speed at least in a range of 120 rpm to 300 rpm. By rotating the rotary table 2 at a high speed, the protective film 650 can be selectively formed on the upper portion of the MOR film 640. Here, in a general film formation process, the rotation speed of the rotary table 2 is often set to about 20 to 30 rpm. Additionally, the rotary table 2 is also configured to rotate at a low speed.

As illustrated in FIGS. 17 and 18, circular recesses 24 for mounting multiple (five in the illustrated example) substrates, which are semiconductor wafers (hereinafter, referred to as "wafers") W, are provided in a surface of the rotary table 2 along a rotational direction (a circumferential direction). Here, in FIG. 18, the wafer W is illustrated in only one of the recesses 24 for convenience. The recess 24 has an inner diameter slightly greater than the diameter of the wafer W by, for example, 4mm, and a depth substantially equal to the thickness of the wafer W. Therefore, when the wafer W is accommodated in the recess 24, the surface of the wafer W and the surface of the rotary table 2 (the region where the wafer W is not mounted) are at the same height. Through-holes (not illustrated), through which three raising/lowering pins to support the back surface of the wafer W and raise and lower the wafer W penetrate, are formed in the bottom surface of the recess 24, for example.

FIGS. 17 and 18 are views for explaining the structure in the vacuum chamber 1, and the illustration of the top plate 11 is omitted for convenience of explanation. As illustrated in FIGS. 17 and 18, a reactive gas nozzle 31, a reactive gas nozzle 32, a reactive gas nozzle 33, and separation gas nozzles 41 and 42, which are made of, for example, quartz, are arranged above the rotary table 2 at intervals in the circumferential direction of the vacuum chamber 1 (the rotational direction of the rotary table 2 (the arrow A in FIG. 18)). In the illustrated example, the separation gas nozzle 41, the reactive gas nozzle 31, the separation gas nozzle 42, the reactive gas nozzle 32, and the reactive gas nozzle 33 are arranged in this order in a clockwise direction (the rotational direction of the rotary table 2). The nozzles 31, 32, 33, 41, and 42 are attached to be introduced from the outer circumferential wall of the vacuum chamber 1 into the vacuum chamber 1 and extend horizontally with respect to the rotary table 2 along the radial direction of the chamber body 12 by fixing gas introduction ports 31a, 32a, 33a, 41a, and 42a (FIG. 18), which are base ends of the nozzles 31, 32, 33, 41, and 42, to an outer circumferential wall of the chamber body 12.

In the present embodiment, as illustrated in FIG. 18, the reactive gas nozzle 31 is connected to a supply source 130 of the source gas (the metal-containing precursor) via a pipe 110, a flow rate controller 120, and the like. The reactive gas nozzle 32 is connected to an oxidizing gas (H₂O₂, O₃, or both) supply source 131 via a pipe 111, a flow rate controller 121, and the like. Further, the reactive gas nozzle 33 is connected to an etching gas supply source 132 via a pipe 112, a flow rate controller 122, and the like. As the etching gas, a halogen-based gas containing a fluorine-based gas, such as CF₄, C₂F₆, CH₃F, CHF₃, Cl₂, ClF₃, BCl₃, or NF₃, can be used; however, there is no particular limitation as long as it can be used for etching. The separation gas nozzles 41 and 42 are connected to a separation gas supply source (not illustrated) via a pipe, a flow rate control valve, and the like (not illustrated). As the separation gas, a rare gas, such as helium (He) or argon (Ar), or an inert gas, such as nitrogen gas (N₂), can be used. In the present embodiment, an example of using the N₂ gas as the separation gas will be described.

As the source gas supplied from the reactive gas nozzle 31, any organic metal gas or organic metalloid gas can be used from among organic metal gases or organic metalloid gases depending on the intended use.

In each of the reactive gas nozzles 31, 32, and 33, multiple gas discharge holes that are opened toward the rotary table 2 are arranged at intervals of, for example, 10 mm along the longitudinal direction of the reactive gas nozzles 31, 32, and 33. A region below the reactive gas nozzle 31 serves as a first processing region P1 for adsorbing the source gas onto the wafer W. A region below the reactive gas nozzle 32 serves as a second processing region P2 where an oxidizing gas for oxidizing the source gas adsorbed on the wafer W in the first processing region P1 is supplied to generate a molecular layer of an oxide of the organic metal or organic metalloid contained in the source gas as a reactive product. Here, the molecular layer of the organic metal oxide or the organic metalloid oxide constitutes the protective film 650 to be formed. A region below the reactive gas nozzle 33 becomes a third processing region P3 where, after the organic metal oxide or the organic metalloid oxide (the protective film 650) generated by the oxidation has been grown upward in the second processing region P2, the unnecessary protective film 650 grown in the lateral direction is removed by etching. As schematically illustrated in FIG. 18, a plasma generator 80 (in FIG. 18, the position where the plasma generator 80 is provided is illustrated by a dashed line) may be provided in the third processing region P3 as necessary. Additionally, in the second processing region P2, an activated oxygen gas may be supplied. For example, an oxygen gas activated by thermal oxidation may be supplied, or an oxygen gas activated by plasma may be supplied. When the oxidizing gas is activated by plasma, a plasma generator may be provided in the second processing region P2.

Here, the first processing region P1 is a region where the source gas is adsorbed onto the wafer W, and thus may be referred to as a source gas adsorption region P1. The second processing region P2 is a region where the source gas adsorbed on the surface of the wafer W is oxidized, and thus may be referred to as an oxidation region P2. Additionally, the third processing region P3 is a region where the side surface of the protective film 650 is etched, and thus may be referred to as an etching region P3.

It is not necessary to provide the plasma generator 80 above the third processing region P3. For example, when a gas having a sufficiently strong etching strength, for example, ClF₃, HF, or the like is used as an etching gas, etching can be performed without using the plasma generator 80. Therefore, the plasma generator 80 may be provided as necessary.

As described above, the source gas supplied from the reactive gas nozzle 31 is the organic metal gas or the organic metalloid gas. As the source gas, any organic metal gas or organic metalloid gas can be used, and the source gas is selected depending on the type of the protective film to be formed. The organic metal gas may be a gas containing an organic metal. For example, when the protective film 650 of TiO₂ is formed, a gas containing organic amino titanium, such as tetrakis(dimethylamino) titanium (TDMAT), is selected. Additionally, as the organic metalloid gas, an organic silane gas, for example, an organic aminosilane gas, such as 3DMASi, may be used. When such an organic metal gas or organic metalloid gas is supplied, a configuration may be used in which an organic metal or organic metalloid is vaporized by using a vaporizer or the like to generate the organic metal gas or the organic metalloid gas, and the generated organic metal gas or the organic metalloid gas is supplied into the vacuum chamber 1 by using a carrier gas, if necessary.

Additionally, as the oxidizing gas supplied from the reactive gas nozzle 32, any oxidizing gas may be used as long as the oxidizing gas can react with the supplied organic metal gas or organic metalloid gas to generate an organic metal oxide. For example, when the organic metal gas is oxidized by thermal oxidation and the MOR film 640 is also oxidized, H₂O₂, O₃, or both are selected.

As the etching gas supplied from the reactive gas nozzle 33, any etching gas can be selected as long as the protective film formed of the organic metal oxide film or the organic metalloid oxide film can be etched. For example, a fluorine-containing gas may be used. Examples of the fluorine-containing gas include CF₄, ClF₃, and the like. As described above, it may be determined whether the plasma generator 80 is provided according to the selected etching gas.

Referring to FIGS. 17 and 18, two protrusions 4 are provided in the vacuum chamber 1. The protrusions 4 are attached to the back surface of the top plate 11 so as to protrude toward the rotary table 2, as described later, in order to constitute separation regions D together with the separation gas nozzles 41 and 42. Additionally, the protrusion 4 has a fan planar shape with an apex portion being cut in an arc shape, and in the present embodiment, the protrusion 4 is disposed such that an inner arc is connected to a projection 5 (to be described later) and an outer arc is along an inner circumferential surface of the chamber body 12 of the vacuum chamber 1.

The protrusion 4 is attached to the back surface of the top plate 11, and thus there are a flat low ceiling surface 44 (a first ceiling surface), which is a lower surface of the protrusion 4, and ceiling surfaces 45 (second ceiling surfaces), which are positioned at both sides of the ceiling surface 44 in the circumferential direction and are higher than the ceiling surface 44 in the vacuum chamber 1. The ceiling surface 44 has a fan planar shape with an apex portion being cut in an arc shape. Additionally, as illustrated, a groove 43 is formed in the protrusion 4 at the center in the circumferential direction so as to extend in the radial direction, and the separation gas nozzle 42 is accommodated in the groove 43. The groove 43 is similarly formed in the other protrusion 4, and the separation gas nozzle 41 is accommodated herein. Additionally, the reactive gas nozzles 31 and 32 are respectively provided in spaces below the high ceiling surfaces 45. The reactive gas nozzles 31 and 32 are provided in the vicinity of the wafer W to be spaced apart from the ceiling surfaces 45. Here, the reactive gas nozzle 31 is provided in a right space below the high ceiling surface 45, and the reactive gas nozzle 32 is provided in a left space below the high ceiling surface 45.

Additionally, in the separation gas nozzles 41 and 42 accommodated in the grooves 43 of the protrusions 4, multiple gas discharge holes opened toward the rotary table 2 are arranged at intervals of, for example, 10 mm along the longitudinal direction of the separation gas nozzles 41 and 42.

The ceiling surface 44 forms a separation space, which is a narrow space, with respect to the rotary table 2. When the N₂ gas is supplied from the discharge holes of the separation gas nozzle 42, the N₂ gas flows toward the space including the processing region P1 and the space including the processing regions P2 and P3 through the separation space. At this time, the volume of the separation space is smaller than the volumes of the space including the processing region P1 and the space including the processing regions P2 and P3, and thus the pressure of the separation space can be made higher than the pressures of the space including the processing region P1 and the space including the processing regions P2 and P3 by the N₂ gas. That is, a high-pressure separation space is formed between the space including the processing region P1 and the space including the processing regions P2 and P3. Additionally, the N₂ gas flowing from the separation space to the space including the processing region P1 and the space including the processing regions P2 and P3 acts as a counter flow with respect to the source gas from the first processing region P1 and the reactive gas from the second processing region P2. Thus, the source gas from the first processing region P1 and the second reactive gas from the second processing region P2 are separated by the separation space. Thereby, preventing the source gas and the reactive gas from being mixed and reacting with each other in the vacuum chamber 1.

Here, the height of the ceiling surface 44 with respect to the upper surface of the rotary table 2 is preferably set to a height suitable for making the pressure of the separation space higher than the pressures of the space including the processing region P1 and the space including the processing regions P2 and P3 in consideration of the pressure inside the vacuum chamber 1, the rotation speed of the rotary table 2, and the supply amount of the separation gas (N₂ gas) to be supplied, during the deposition.

With respect to the above, the projection 5 surrounding the outer periphery of the core 21 for fixing the rotary table 2 is provided on the lower surface of the top plate 11. In the present embodiment, the projection 5 is continuous with a portion of the protrusion 4 on the rotation center side, and the lower surface thereof is formed at the same height as the ceiling surface 44.

A bent portion 46 bent in an L shape is formed at a peripheral portion of the fan-shaped protrusion 4 (a portion of the vacuum chamber 1 on the outer edge side) so as to face the outer end surface of the rotary table 2. The bent portion 46 suppresses the reactive gas from entering from both sides of the separation region D and suppresses both of the reactive gases from being mixed, similarly to the protrusion 4. The fan-shaped protrusion 4 is provided on the top plate 11 and the top plate 11 is detachable from the chamber body 12, and thus a slight gap is formed between the outer peripheral surface of the bent portion 46 and the chamber body 12. A gap between the inner peripheral surface of the bent portion 46 and the outer end surface of the rotary table 2 and a gap between the outer peripheral surface of the bent portion 46 and the chamber body 12 are set to be the same size as the height of the ceiling surface 44 with respect to the upper surface of the rotary table 2, for example.

An inner peripheral wall of the chamber body 12 is formed as a vertical surface close to the outer peripheral surface of the bent portion 46 in the separation region D, but is recessed outward throughout a region from a portion facing the outer end surface of the rotary table 2 to the bottom 14 in a portion other than the separation region D, as illustrated in FIG. 16, for example. Hereinafter, for convenience of description, the recessed portion having a substantially rectangular cross-sectional shape is referred to as an exhaust region. Specifically, the exhaust region communicating with the first processing region P1 is referred to as a first exhaust region E1, and the region communicating with the second and third processing regions P2 and P3 is referred to as a second exhaust region E2. As illustrated in FIGS. 16 to 18, a first exhaust port 61 and a second exhaust port 62 are formed in bottoms of the first exhaust region E1 and the second exhaust region E2, respectively. As illustrated in FIG. 16, the first exhaust port 61 and the second exhaust port 62 are connected to a vacuum pump 64, which is a vacuum exhaust means, via respective exhaust pipes 63, for example. Additionally, a pressure controller 65 is provided between the vacuum pump 64 and the exhaust pipe 63.

As illustrated in FIG. 16, a heater unit 7, which is a heating means, is provided in a space between the rotary table 2 and the bottom 14 of the vacuum chamber 1, and the wafer W on the rotary table 2 is heated to a temperature (for example, 150°C) determined by a process recipe via the rotary table 2. A ring-shaped cover member 71 is provided below the vicinity of the periphery of the rotary table 2 to partition an atmosphere from the space above the rotary table 2 to the exhaust regions E1 and E2 from an atmosphere in which the heater unit 7 is placed, to suppress a gas from entering the region below the rotary table 2. The cover member 71 includes an inner member 71a provided to face an outer edge of the rotary table 2 and an outer peripheral side of the outer edge from the lower side, and an outer member (not illustrated) provided between the inner member 71a and the inner surface of the vacuum chamber 1. The outer member (not illustrated) is provided below the bent portion 46 and adjacent to the bent portion 46 formed at the outer edge of the protrusion 4 in the separation region D, and the inner member 71a surrounds the heater unit 7 throughout the entire circumference below the outer edge of the rotary table 2 (and below a portion slightly outside the outer edge).

The bottom 14 at a portion closer to the rotation center than the space where the heater unit 7 is disposed projects upward to approach the core 21 near the center of the lower surface of the rotary table 2, which forms a projection 12a. A narrow space is formed between the projection 12a and the core 21, and a narrow gap is formed between the inner peripheral surface of the through-hole of the rotary shaft 22 passing through the bottom 14 and the rotary shaft 22, and these narrow spaces communicate with the case body 20. In the case body 20, a purge gas supply pipe 72 for supplying an N₂ gas, which is a purge gas, into the narrow space to purge the narrow space is provided. Additionally, multiple purge gas supply pipes 73 for purging the space where the heater unit 7 is disposed are provided at the bottom 14 of the vacuum chamber 1 below the heater unit 7 at predetermined angular intervals in the circumferential direction. Additionally, a cover member 7a is provided between the heater unit 7 and the rotary table 2 to cover a space from an inner peripheral wall (an upper surface of the inner member 71a) of the outer member (not illustrated) to an upper end of the projection 12a in the circumferential direction in order to suppress the gas from entering the region where the heater unit 7 is provided. The cover member 7a can be made of, for example, quartz.

Additionally, a configuration is used in which a separation gas supply pipe 51 is connected to the center of the top plate 11 of the vacuum chamber 1, and N₂ gas, which is the separation gas, is supplied to the space between the top plate 11 and the core 21. The separation gas supplied to the space including a central region C is discharged toward the peripheral edge along the surface of the rotary table 2 on the wafer mounting region side via the narrow gap between the projection 5 and the rotary table 2. The space including the central region C may be maintained at a pressure higher than the pressure in the space including the processing region P1 and the space including the processing regions P2 and P3 by the separation gas. Therefore, the space including the central region C suppresses the organic metal gas supplied to the first processing region P1 and the oxidizing gas supplied to the second processing region P2 from being mixed through the central region C. That is, the space including the central region C (or the central region C) can function similarly to the separation space (or the separation region D).

Further, as illustrated in FIGS. 17 and 18, a transfer port 15 for transferring the wafer W, which is the substrate, between an external transfer arm 10 and the rotary table 2 is formed in the sidewall of the vacuum chamber 1. The transfer port 15 is opened and closed by a gate valve (not illustrated). Additionally, the wafer W is transferred between the recess 24, which is the wafer mounting region of the rotary table 2, and the transfer arm 10 at a position facing the transfer port 15, and thus a transfer raising/lowering pin and a raising/lowering mechanism (both not illustrated) for raising the wafer W from the back surface through the recess 24 are provided at a portion corresponding to a transfer position below the rotary table 2.

Additionally, as illustrated in FIG. 16, in the film deposition apparatus according to the present embodiment, a controller 100 formed by a computer for controlling the operation of the entire apparatus is provided, and a program for causing the film deposition apparatus to perform a protective film formation method to be described later under the control of the controller 100 is stored in a memory of the controller 100. The program includes steps for executing the protective film formation method to be described later, and is stored in a medium 102, such as a hard disk, a compact disc, a magneto-optical disk, a memory card, or a flexible disk, and is read into a storage unit 101 by a predetermined reading device and installed in the controller 100.

Here, the controller 100 may also control the rotational speed of the rotary table 2. With this, the rotational speed of the rotary table 2 can be set to a high speed rotation, such as 120 rpm or greater or 120 rpm to 300 rpm as described above, or a low speed rotation, such as 60 rpm.

Additionally, the controller 100 may control the flow rate controllers 120 to 122. With this, the flow rate of the gas supplied from each of the gas nozzles 31 to 33 can be controlled.

With such a configuration, in the protective film formation process in step S305, the source gas (the metal-containing precursor) is supplied from the supply source 130 to the first processing region P1, and the oxidizing gas is supplied from the supply source 131 to the second processing region P2. Additionally, the separation gas is supplied to the separation region D. The wafer W, which is the substrate, disposed in the recess 24 of the rotary table 2, passes through the first processing region P1 (the source gas adsorption region P1), the separation region D, the second processing region P2 (the oxidation region P2), and the separation region D every time the rotary table 2 rotates once. That is, the processes of steps S312 and S313 are repeated every time the rotary table 2 rotates. With this, the protective film 650 is formed. Additionally, by rotating the rotary table 2 at a high speed, the source gas is selectively adsorbed on the upper portion of the MOR film 640, and the protective film 650 is selectively formed on the upper portion of the MOR film 640.

Additionally, in the protective film shaping process in step S306, the etching gas is supplied from the supply source 132 to the third processing region P3. Additionally, the separation gas is supplied to the separation region D. With this, a portion of the protective film 650 is removed to shape the protective film 650.

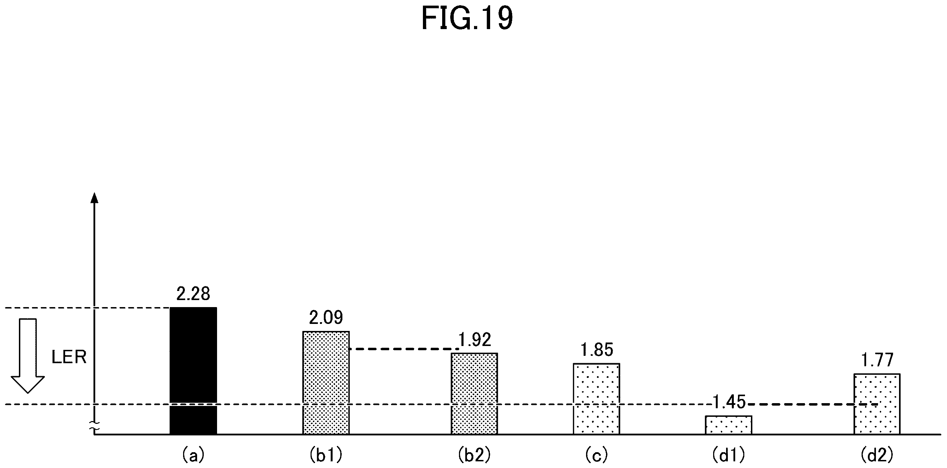

Next, the linearity of the edge (the sidewall) of the trench-shaped pattern will be further described with reference to FIG. 19. FIG. 19 is an example of a graph indicating the line edge roughness (LER).

Here, the trench-shaped pattern was formed in the MOR film 640. Then, the etching process is performed on the silicon-containing film 630, which was the underlayer, using the modified MOR film 645 having the trench-shaped pattern as a mask, thereby forming the trench-shaped pattern in the silicon-containing film 630. The line edge roughness of the trench-shaped pattern formed in the silicon-containing film 630 was measured.
(a) indicates the line edge roughness (LER) in a case where the underlayer is etched using the unmodified MOR film 640.
(b1) and (b2) indicate the line edge roughness (LER) in a case where the underlayer is etched using the modified MOR film 645 without forming the protective film 650. Here, the mean value of (b1) and (b2) is illustrated by the dashed line.
(c) indicates the line edge roughness (LER) in a case where the underlayer is etched using the modified MOR film 645 in which the protective film 650 has been formed.
(d1) and (d2) indicate the line edge roughness (LER) in a case where the protective film shaping process illustrated in step S306 is performed and the underlayer is etched using the modified MOR film 645 in which the protective film 350 has been formed. The mean value of (d1) and (d2) is illustrated by the dashed line.

As indicated by comparing (a), (b1), and (b2), it is indicated that the line edge roughness (LER) is improved by forming the pattern of the recess 662 in the silicon-containing film 630.

Further, as indicated by comparing (b1), (b2), and (c), it is indicated that the line edge roughness (LER) is further improved by forming the protective film 650.

As indicated by comparing (c), (d1), and (d2), it is indicated that the line edge roughness (LER) is further improved by performing the protective film shaping process (see step S306). Therefore, in comparison with the case of forming the trench-shaped pattern in the underlayer by using the MOR film 640 on which the modification process is not performed as illustrated in (a), the line edge roughness can be reduced (see the arrow of FIG. 19).

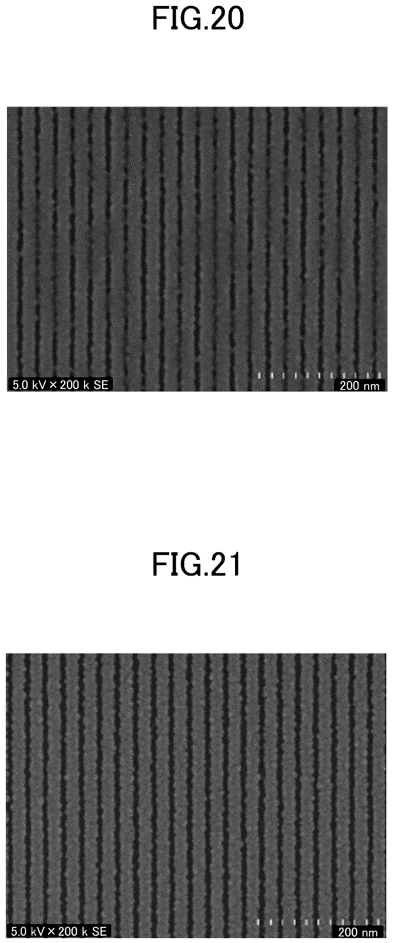

FIG. 20 is a view illustrating a result of the trench shape in a case where the annealing process in step S304 is omitted and the protective film 650 is formed. FIG. 21 is a view illustrating a result of the trench shape in a case where the annealing process in step S304 is performed and the protective film 650 is formed.

In the case where the annealing process is omitted and the protective film 650 is formed, the protective film 650 is also formed on the projection 641 (see FIG. 8), and thus an overhang is formed in the protective film 650 to cover the opening 661. With this, as illustrated in FIG. 20, a projection extending from one sidewall of the opening 661 to the other sidewall of the opening 661 appears.

In contrast, in the case where the annealing process is performed and the protective film 650 is formed, overhang of the protective film 650 is suppressed.

### <Fourth Embodiment>

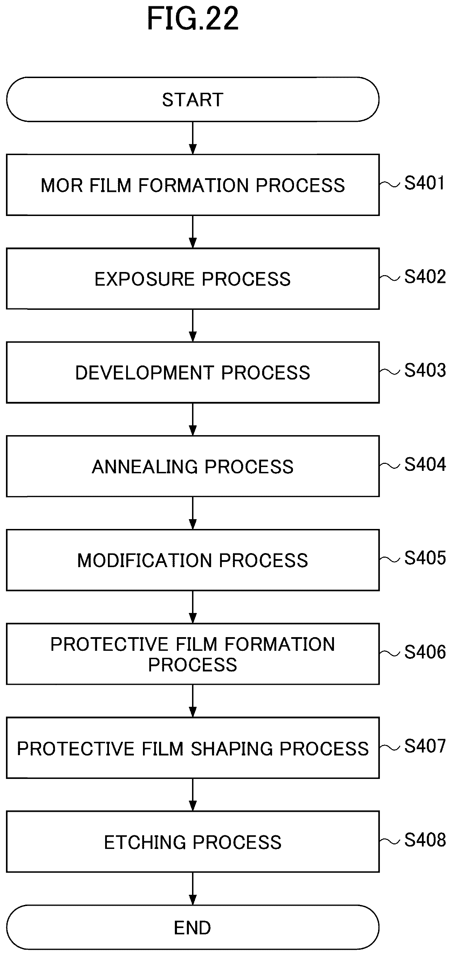

Next, an example of a substrate processing method according to a fourth embodiment will be described with reference to FIG. 22.

FIG. 22 is an example of a flowchart illustrating the substrate processing method according to the fourth embodiment.

In step S401, the process (the MOR film formation process) of forming the MOR film 640 made of a metal oxide is performed on the substrate including the underlayer. Next, the process of forming the pattern in the MOR film 640 is performed. First, in step S402, the exposure process is performed on the substrate. Next, in step S403, the development process is performed on the substrate. Next, in step S404, the annealing process is performed on the substrate. Next, in step S405, the modification process is performed on the substrate. Here, the processes from step S401 to step S405 are substantially the same as the processes from step S201 to step S205 (see FIG. 7), and thus the duplicated description will be omitted. Here, the annealing process in step S404 may be omitted.

In step S406, the process (the protective film formation process) of forming the protective film 650 in the upper portion of the modified MOR film 645 is performed. Here, the process in step S406 is substantially the same as the process in step S305 (see FIG. 12), and thus the duplicated description will be omitted. Additionally, in the flowchart of FIG. 13, the description is provided assuming that the reactive gas to be reacted with the metal-containing precursor is the oxidizing gas (see step S313), but is not limited thereto. As the reactive gas, a nitriding gas may be used instead of the oxidizing gas. Here, the protective film 650 is, for example, any of a titanium oxide film, a titanium oxynitride film, an aluminum oxide film, a silicon oxide film, a titanium nitride film, or a silicon nitride film. Additionally, the protective film 650 has a higher etching resistance than the silicon-containing film 630 under the condition of the etching process in step S408 described later.

In step S407, the protective film shaping process is performed on the substrate. In step S408, the etching process is performed on the substrate. Here, the processes from step S407 to step S408 are substantially the same as the processes from step S306 to step S307 (see FIG. 12), and thus the duplicated description will be omitted. With this, the pattern of the recess 662 is formed in the silicon-containing film 630 (see FIG. 5). Additionally, the protective film 650 has a higher etching resistance than the silicon-containing film 630. With this, the selectivity of the etching process is improved. Additionally, according to the substrate processing method of the fourth embodiment, the reactive gas for forming the protective film 650 may be the same gas as the oxidizing gas for modifying the MOR film 640, or may be a different gas.

### <Substrate Processing System>

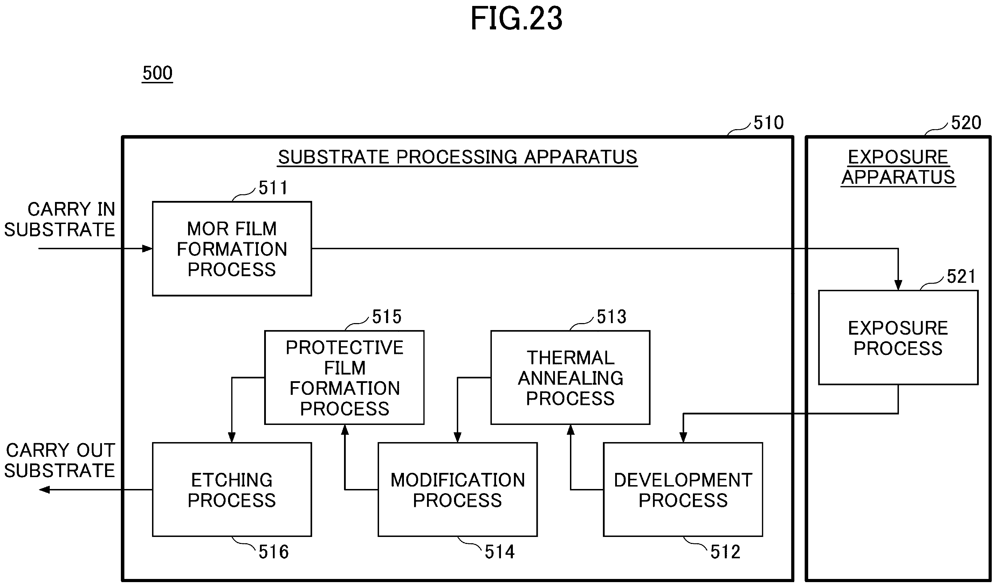

Next, an example of a substrate processing system 500 will be described with reference to FIG. 23. FIG. 23 is a block diagram illustrating the example of the substrate processing system 500.

The substrate processing system 500 includes a substrate processing apparatus 510 and an exposure apparatus 520. The substrate processing apparatus 510 includes one or more processing chambers for performing one or more processes selected from a MOR film formation process 511, a development process 512, a thermal annealing process 513, a modification process 514, a protective film formation process 515, and an etching process 516. The exposure apparatus 520 includes a processing chamber for performing an exposure process 521.

The substrate processing apparatus 510 and the exposure apparatus 520 may be connected in-line. The MOR film formation process 511, the development process 512, the thermal annealing process 513, the modification process 514, the protective film formation process 515, and the etching process 516 may be performed in different process chambers. Alternatively, multiple processes selected from the MOR film formation process 511, the development process 512, the thermal annealing process 513, the modification process 514, the protective film formation process 515, and the etching process 516 may be performed in the same process chamber.

Although the embodiments and the like of the plasma processing system have been described above, the present disclosure is not limited to the above-described embodiments, and various modifications and improvements can be made within the scope of the present disclosure described in the appended claims.

This application claims priority to U.S. Provisional Application No. 63/366,346, filed Jun. 14, 2022, the entire contents of which are incorporated herein by reference.

### Description of reference symbols

610: base material
620: organic film
630: silicon-containing film
640 MOR film (metal oxide resist film)
645 modified MOR film (metal oxide resist film)
641 projection
642 residue
643 sidewall
644 upper surface
650: protective film
661 opening
662 recess

## Claims

1. A substrate processing method comprising:
a step of forming a metal oxide resist film on a substrate including an underlayer;
a step of forming a pattern in the metal oxide resist film;
a step of modifying the metal oxide resist film in which the pattern has been formed; and
a step of etching the underlayer by using the modified metal oxide resist film as a mask.

2. The substrate processing method as claimed in claim 1, wherein the step of modifying the metal oxide resist film includes a process of oxidizing the metal oxide resist film.

3. The substrate processing method as claimed in claim 2, wherein the step of modifying the metal oxide resist film includes a process of exposing the substrate to hydrogen peroxide, ozone, or both.

4. The substrate processing method as claimed in claim 1, further comprising a step of performing an annealing process on the substrate, after the step of forming the pattern in the metal oxide resist film yet before the step of modifying the metal oxide resist film.

5. The substrate processing method as claimed in claim 1, further comprising a step of forming a protective film in a non-recessed shape formed region of the metal oxide resist film after the step of forming the pattern in the metal oxide resist film,
wherein the step of forming the protective film includes:
a step of providing a metal-containing precursor; and
a step of supplying an oxidizing gas that also serves the step of modifying the metal oxide resist film.

6. The substrate processing method as claimed in claim 5, wherein the protective film is any of a titanium oxide film, a titanium oxynitride film, an aluminum oxide film, or a silicon oxide film.

7. The substrate processing method as claimed in claim 1, further comprising a step of forming a protective film in a non-recessed shape formed region of the metal oxide resist film after the step of modifying the metal oxide resist film,
wherein the step of forming the protective film includes:
a step of providing a metal-containing precursor; and
a step of supplying a reactive gas.

8. The substrate processing method as claimed in claim 7, wherein the protective film is any of a titanium oxide film, a titanium oxynitride film, an aluminum oxide film, a silicon oxide film, a titanium nitride film, or a silicon nitride film.

9. The substrate processing method as claimed in any one of claims 5 to 8, further comprising a step of performing a process of shaping the protective film after the step of forming the protective film yet before the step of etching the underlayer.

10. A substrate processing system comprising:
a film deposition apparatus configured to perform a process of forming a metal oxide resist film on a substrate including an underlayer;
an exposure apparatus configured to perform an exposure process on the substrate on which the metal oxide resist film has been formed;
a development apparatus configured to perform a development process on the substrate on which the exposure process has been performed;
a modification apparatus configured to modify the metal oxide resist film on the substrate on which the development process has been performed; and
an etching apparatus configured to etch the underlayer by using the modified metal oxide resist film as a mask.
